# EUROPEAN PATENT SPECIFICATION

(11) **EP 2 273 553 B1**
(45) Date of publication and mention of the grant of the patent: **12.02.2020**
(21) Application number: 10185047.7
(22) Date of filing: 30.06.2005
(51) Int. Cl.: H01L 29/778, H01L 21/335, H01L 23/31, H01L 29/20, H01L 29/51, H01L 23/29

(54) **A method for fabricating AlGaN/GaN HEMT devices**
Verfahren zur Herstellung von AlGaN/GaN HEMT Anordnungen
Méthode de fabrication de dispositifs HEMT en AlGaN/GaN

(30) Priority: 30.06.2004 US 584687 P; 30.11.2004 EP 04447267
(43) Date of publication of application: 12.01.2011
(62) Divisional of application: 05447155.2
(73) Proprietor: IMEC VZW, 3001 Leuven (BE)
(72) Inventor: Germain, Marianne, 4000 Liege (BE); Derluyn, Joff, 1000 Brussel (BE); Leys, Maarten, 5642 NT Eindhoven (NL)
(74) Representative: Pronovem

(56) References cited:
- EP-A2- 1 817 798
- US-A- 5 929 467
- US-A1- 2002 167 023
- US-A1- 2003 020 092
- KIKKAWA T ET AL: "A 36 W CW ALGAN/GAN-POWER HEMT USING SURFACE-CHARGE-CONTROLLED STRUCTURE", 2002 IEEE MTT-S INTERNATIONAL MICROWAVE SYMPOSIUM DIGEST (CAT. NO.02CH37278) IEEE PISCATAWAY, NJ, USA; [IEEE MTT-S INTERNATIONAL MICROWAVE SYMPOSIUM], IEEE, 2 June 2002 (2002-06-02), pages 1815-1818, XP001113957, DOI: 10.1109/MWSYM.2002.1012215 ISBN: 978-0-7803-7239-9

## Description

### Field of the invention

The invention relates to the group III-nitride field effect devices, and methods to improve stability of the surface, by passivation of the top surface, as well as to ohmic contact deposition on wide bandgap layers.

### Background description and technology problems

GaN Field-effect devices are piezoelectric devices, i.e. the presence of spontaneous and piezoelectric polarizations are responsible for charge separation within the material.

This has the enormous advantage that it allows, at the interfaces between different material composition, e.g. AlGaN and GaN, the creation of surface charged layers in the structures. Those surface charged layers are compensated in the AlGaN/GaN junction by the formation of two-dimensional electron gas (2DEG) at the other side of the interface, which has high mobility values compared to the bulk material. If necessary and beneficial for the creation of very high mobility channel in the structure, allowing for demonstration of high power HEMT devices, it has the drawback that the separation charges within wurtzite material, is also responsible for the surface charged layer at the top surface of the structure, leading to an increased importance of surface states, compared to zincblend structure materials. Presence of surface states creates acute problems for achieving the high performance that are theoretically predicted for those devices, as surface states play an important role during device operation. It has been noticed by many authors that the reduction of dc performance, current slump at high drain-source voltages, DC to RF dispersion phenomena, are directly related to the filling, emptying of surface states, although thermal effects are also partially responsible for dc current slump.

To minimize the effect of such surface states on the top III-N structures, passivation of the surface between drain and source by e.g. SiN, SiO₂, has been proposed by different authors, using essentially ex-situ methods, during the processing of the transistors. These methods are very dependent on the growth conditions of the oxide or insulating layer on the top surface, as strain effects, tuned by growth conditions and also dependent on the strain state in the heterostructure itself, also have a influence on the two-dimensional electron gas properties. They are also very dependent on the chemical or mechanical state of the surface, which is depending on the previous processing steps that have occurred on this top surface.

US 2003/0020092 A1 describes an AlGaN/GaN HEMT having a thin AIGaN layer. Source and drain contacts contact the AIGaN layer, while parts of the AIGaN layer being uncovered by the contacts. An insulating layer covers the uncovered part of the AIGaN layer and a gate contact is included on the insulating layer. In an embodiment, the HEMT and the insulating layer are fabricated using metal-organic chemical vapour deposition. In another embodiment, the insulating layer is sputtered onto the top surface of the HEMT active layers.

WO 01/13436 A1 describes a GaN based FET that employs dielectric passivation layers on exposed AlGaN or GaN surfaces of the devices above the channel regions, between the source and drain contacts. The dielectric layer is formed of SiN. The layer controls undesirable frequency-dependent current and reduced breakdown voltage.

US 5,192,987 recites a high electron mobility transistor. The transistor consists of a GaN/AlGaN heterojunction, where a two-dimensional electron gas occurs. The structures are deposited on basal plane sapphire using low-pressure metal organic chemical vapour deposition.

Another problem in the development of field-effect GaN based transistors is the ohmic contact formation on the group III-nitride surface. The ohmic contact formation is dependent on different factors, e.g. the surface composition, but one very important, which has long been underestimated, is the degree of oxidation of the top surface. Different cleaning techniques and metallization techniques have been suggested to overcome this problem. The lack of a good ohmic contact formation on the top layer directly leads to drastic reduction of the device performance. It is very often observed that the maximum current which is measured, under dc conditions, is well below the maximum current density values deduced from material considerations such as carrier density and mobility in the channel.

Furthermore, the uniformity and reproducibility of the device performances over a wafer and from wafer to another is often a problem. Even if record performance has been demonstrated on selected HEMT devices, uniformity and reproducibility of the results remain problematic. Although improvement of material quality and device processing is believed to allow for better results in uniformity and reproducibility, a fundamental problem to be overcome is the accurate control of the surface properties.

Finally, another problem, frequently encountered with piezoelectric devices such as AlGaN/GaN HEMT devices is the following. In order to increase the current density in the two-dimensional electron gas, there exist two possibilities: either increase the AlGaN layer thickness, or increase the Al content in this top surface. These two possibilities, by increasing the strain in the top AlGaN, which is grown pseudomorphically on the GaN layer, leads to an increased carrier density in the channel. However, the presence of high strain in the AlGaN layer rapidly leads to cracking of this top surface. Those cracks in the AlGaN are very prejudicial, they destroy the 2DEG at the AlGaN/GaN interface; second, they complicate processing. It would therefore be interesting to find a possibility of preventing crack appearance in the top AlGaN, even for highly strained layers. It is important to note that most of these cracks are believed to occur during the cooling down of the structure. An effective way of reducing cracks appearance in III-N devices is even more highly demanded when growing these III-N devices on Si substrates, as differences in thermal expansion coefficients are even larger than with SiC or sapphire substrates.
Document EP1817798 describes a method for producing a Group III-nitride high electron mobility transistor comprising a channel layer, a barrier layer on the channel layer, a passivation layer on the barrier layer, and gate, source and drain contacts directly and entirely on the passivation layer, wherein the passivation layer may consist of SiN, and wherein the passivation layer may be formed in-situ with the formation of the barrier layer.

### Summary of the invention

It is an aim of the invention to stabilize the surface of the GaN field-effect devices prior surface contamination by air exposure and any damaging through different processing steps, in order to have an increased electron density in the channel and a high performance device, as well as a reliable process.

It is a further aim to have a reduced ohmic contact resistance.

It is a further aim of the invention to increase the two-dimensional electron gas, by reducing the strain-induced modification during cooling down, by allowing for higher strain in the heterostructure without damaging the mechanical properties of the top surface and thus directly increase the HEMT performance.

The invention is related to a method for fabricating a semiconductor device according to the appended claims. The method comprises the steps of:
- placing a substrate in a reaction chamber,
- depositing a first active layer, comprising a group III nitride semiconductor material,
- depositing on said first active layer a second active layer having a higher bandgap than said first active layer, thereby forming a two-dimensional electron gas layer between said first active layer and said second active layer,
- depositing on said second active layer a passivation layer,
- depositing directly and entirely on said passivation layer a source contact and a drain contact,
wherein said steps of depositing said first, second active layers and said passivation layer are performed in said reaction chamber without subjecting the layers to air or environment. Said passivation layer consists of an electron donating element and nitrogen, except SiN (i.e. the passivation layer does not consist of SiN).

Between the first active layer and the second active layer (also called the interface), surface charged layers could be created in the device. The surface charged layers are compensated by the formation of two-dimensional electron gas at the other side of the interface, resulting in high mobility values compared to the bulk material. This is beneficial for the creation of a very high mobility channel in the device.

In another embodiment, a spacer layer is present between the first active layer and the second active layer. The spacer layer is selected such that the mobility at the interface is increased.

The spacer layer can be formed of, but is not limited hereto, AlN.

In another embodiment, the second active layer is partly or entirely doped with donor elements such as Si, to provide another source of electrons.

In another embodiment, the second active layer is covered by a third layer, the third layer being formed of a Group III nitride material such as, but not limited hereto, GaN. The third layer is between the second active layer and the passivation layer.

The passivation layer is arranged such that it reduces or eliminates the effect of surface states on the carrier density in the two-dimensional electron gas, during device operation.

Although the invention is not limited to this, a possible explanation of such an effect is that the passivation layer could provide a charge neutral interface with the AIGaN, eliminating surface depletion of the 2DEG. The presence of high level of donor-type of defects in the passivation layer could be beneficial for the compensation of surface charge effects. Presence of surface states creates accurate problems for achieving the high performance, as surface states play an important role during device operation.

The thickness of the passivation layer is between 1 nm and 100 nm, between 1 nm and 50 nm, between 1 nm and 30 nm, or between 1 nm and 20 nm. Preferably, the thickness is between 1 nm and 30 nm.

The passivation layer is characterized by an amorphous structure.

Furthermore, a thin passivation layer allows the formation of ohmic contacts with a low resistance.

Furthermore, if the passivation layer comprises Si, the Si can diffuse in the AlGaN, where it acts as a donor.

The introduction of a donor type in the AlGaN layer facilitates the ohmic contact formation reducing thereby the contact resistance.

The first active layer, the second active layer and the passivation layer are formed in the same reactor without subjecting the layers to air.

Preferably, the passivation layer is formed by MOVPE (Metal-Organic Vapour Phase Epitaxy) or MBE (Molecular Beam Epitaxy).

In a further embodiment, the second active layer is not covered with an oxide layer. The passivation layer is in direct contact with the second active layer.

In another preferred embodiment, the source contact and drain contact are made of an alloy comprising Ti, Al, Ni, Mo, Ta, Pt, Pd, V, Nb, Zr and/or Au. The contact being preferably formed by Ti/Al/Ti/Au sequence, Ti/Al/Ni/Au, Ti/Al/Mo/Au or Ti/Al/Pt/Au.

It is probable that, when one of the layers is made of Al, the latter easily forms an alloy with nitrogen, AlN, and that silicon acts as a dopant in the AIGaN layer. This facilitates the ohmic contact formation.

The method according to the invention comprises the steps of:
- placing a substrate in a reaction chamber
- forming a first active layer on said substrate
- forming a second active layer on said first active layer, said second active layer having a higher bandgap than said first active layer, thereby forming a two-dimensional electron gas layer between said first active layer and said second active layer,
- forming a passivation layer on said second active layer
- forming a source contact and a drain contact, said source contact and said drain contact contacting said passivation layer, with part of said passivation layer being uncovered by the source contact and the drain contact.

A method according to the invention may further comprise the step of forming a gate contact in electrical contact with said second active layer.

In the method of the invention, the steps of forming a first active layer, forming a second active layer and forming a passivation layer are performed in a reactor chamber without subjecting the device to the air (environment).

More particularly, said reaction chamber can be a MOVPE (Metal Organic Vapour Phase Epitaxy) reaction chamber.

A method of the invention may further comprise the steps of:
- cooling said reaction chamber,
- removing said device with its deposited layers from said reaction chamber,
the cooling step and the removing step being performed after the step of forming a passivation layer and before the step of forming a source and drain contact.

In a method of the invention, the step of forming the passivation layer is preferably performed at a temperature between 700°C and 1300 °C.

In the method of the invention, the steps of forming a source contact and drain contact are performed such that there is a direct contact between the passivation layer and the source contact and the drain contact.

In a method of the invention, the first active layer is preferably formed of a group III nitride semiconductor material, more particularly of GaN.

In a method of the invention, the second active layer is preferably formed of a group III nitride semiconductor material, more particularly of AlGaN or AlGaInN.

In an embodiment of the invention, a method as recited in any of the previous embodiments is disclosed further comprising the step of forming a gate contact in electrical contact with said second active layer. The gate contact is formed on the uncovered part of the passivation layer.

In the invention, the steps of forming a first active layer, forming a second active layer and forming a passivation layer are performed in a reactor chamber without subjecting the device to the air (for the purpose of this invention also called "in situ" formation).

In a preferred embodiment, the reaction chamber is a MOVPE reaction chamber.

The formation of an oxide on the second active layer is substantially avoided. Moreover, the step of removing the oxide layer from the top surface of the second active layer is avoided. This results in an improved ohmic contact formation.

The prior art shows that the oxide which spontaneously forms over the top surface of the second active layer is very stable, and thus requires high power and/or high duration of plasma etching prior effectively eliminating the oxide layer.

In another embodiment of the invention, the method can further comprise the step of forming at least one buffer layer between the substrate and the first active layer.

This step is performed after the step of placing the substrate in the reaction chamber.

The buffer layer provides an appropriate crystal structure transition between the substrate and the remainder of the device.

The buffer layer can be a nucleation layer between the substrate and the first active layer.

In a particular embodiment, the buffer layer can consist of, but is not limited hereto, AlN, GaN, AlGaN or InN or combinations thereof.

In a particular embodiment, the buffer layer is formed at a growth temperature which is lower than the growth temperature of the first active layer.

In another embodiment, the step of forming the passivation layer is performed at a temperature between 700°C and 1300 °C, between 700 °C and 1250 °C, or between 700 °C and 1100°C.

The passivation layer being deposited at least at 700° C on top of the second active layer, preferably AlGaN, results in a reduction of the cracks in the second active layer. Cracks occur when cooling down the device from growth temperature to room temperature. Therefore, it allows increasing either the thickness of the second active layer, and/or the Al content in the second active layer. This results in an increase of the carrier density in the channel.

The step of forming a source contact and drain contact are performed such that there is a direct contact between the passivation layer and the source contact and the drain contact. This means that the passivation layer is not etched before formation of the source and drain contacts.

It should be understood that when SiN is mentioned, a compound consisting of Si and N is meant. SiN can include Si₃N₄, but also other formulas are included, such as, but not limited hereto, SiₓN_{y}, being in different stoichiometric or non-stoichiometric ratios.

In the formula SiₓN_{y}, x and y can be defined as real numbers, with 0 < x ≤ 100 and 0 < y ≤ 100.

In an embodiment of the invention, the step of forming a first active layer comprises flowing source gasses adapted for the formation of the first active layer into a reactor chamber. The step of forming a second active layer comprises flowing source gases adapted for the formation of the second active layer into said reaction chamber. The step of forming the passivation layer comprises flowing source gasses adapted for the formation of the passivation layer into a reactor chamber.

In a further embodiment, the first active layer is formed of a group III nitride semiconductor material. In a preferred embodiment, the first active layer is formed of GaN. In another further embodiment, said second active layer is formed of a group III nitride material. In a preferred embodiment, the second active layer is formed of AIGaN.

### Short description of the drawings

Figure 1 represents a HEMT device obtainable by a method in accordance with the present invention
Figure 2 represents an AlGaN/GaN based HEMT
Figure 3 represents an AIGaN/AIN/GaN based HEMT
Figure 4 represents a GaN/AIGaN/AIN/GaN based HEMT
Figure 5 represents an AlGaN/GaN based HEMT
Figure 6 represents a method for forming a HEMT device
Figure 7 represents a method for forming an AlGaN/GaN based HEMT device
Figure 8 represents Transfer Length Measurements for uncapped and capped HEMT structures at three different temperatures
Figure 9 represents DC drain source current-voltage characteristics for different gate bias voltages.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes

The present invention describes a method that overcomes the problems related to surface stability and homogeneity, as well as a better control of the ohmic contact formation.

A semiconductor device is provided comprising:
- a substrate,
- a first active layer,
- a second active layer (on said first active layer), said second active layer having a higher bandgap than said first active layer,
- a two-dimensional electron gas layer between said first active layer and said second active layer,
- a passivation layer (on said second active layer) consisting of an electron donating element and nitrogen,
- a source contact and a drain contact directly deposited on said passivation layer.

In the context of the present invention and except if specified otherwise, the term "on" when referring to the relative position of two layers, can mean "directly or immediately on" (i.e. without an intermediary layer) or can also mean "above, with one or more intermediary layers".

In particular, in a method or a semiconductor device obtainable by a method according to the invention, said source and drain contacts are (deposited) directly on said passivation layer, i.e. there is no intermediary layer (neither between said source contact (or source electrode) and said passivation layer nor between said drain contact (or drain electrode) and said passivation layer).

It is probable that said electron donating element diffuses in said second active layer and acts there as a donor; and the introduction of a donor type in said second active layer facilitates the ohmic contact formation reducing thereby the contact resistance.

It is also probable that, when one of the layers is made of Al, the latter easily forms an alloy with nitrogen, AlN, and that said electron donating element acts as a dopant in the AIGaN layer. This facilitates the ohmic contact formation.

In a semiconductor device according to the invention, said passivation layer can comprise (or consist of) CN or GeN.

Preferably, said passivation layer has a thickness comprised between (about) 1 nm and (about) 30 nm.

Preferably, said first active layer comprises (or consists of) a group III nitride semiconductor material, more particularly comprises (or consists of) GaN.

Preferably, said second active layer comprises (or consists of) a group III nitride semiconductor material, more particularly comprises (or consists of) AlGaN or AlInN or AlGaInN.

A semiconductor device obtainable by a method according to the invention can further comprise a gate contact in electrical contact with said second active layer.

A semiconductor device obtainable by a method according to the invention can further comprise a spacer layer between said first active layer and said second active layer. Said spacer layer aims at increasing the mobility in said 2DEG layer. For example, said spacer layer can comprise (or consists of) AlN.

A semiconductor device obtainable by a method according to the invention can further comprise a third layer between said second active layer and said passivation layer. Said third layer aims more particularly at providing electrons to the channel. Preferably, said third layer comprises (or consists of) a group III nitride material.

In a semiconductor device obtainable by a method according to the invention, said substrate can comprise (or consist of) a material selected from the group consisting of silicon, sapphire, SiC, GaN and AlN.

The present invention provides a method for fabricating a semiconductor device comprising the steps of:
- placing a substrate in a reaction chamber,
- depositing on said substrate a first active layer,
- depositing on said first active layer a second active layer having a higher bandgap than said first active layer, thereby forming a two-dimensional electron gas layer between said first active layer and said second active layer,
- depositing on said second active layer a passivation layer comprising at least an electron donating element and nitrogen, except SiN,
- depositing directly on said passivation layer a source contact and a drain contact.

In a method of the invention, said steps of depositing said first, second active layers and said passivation layer are performed in said reaction chamber without subjecting the layers to air or environment.

Preferably, a method of the invention further comprises, before the step of depositing the source and drain contacts, the steps of:
- cooling said reaction chamber, and
- removing the device (or structure) (with its deposited layers) from said reaction chamber.

In a method of the invention, said reaction chamber can be a MOVPE or a MBE reaction chamber.

A method according to the invention can further comprise the step of forming a gate contact in electrical contact with said second active layer.

Said gate contact can be deposited directly on said passivation layer (i.e with no intermediary layer).

Alternatively, said passivation layer can be etched, in the channel region, in other words between the source and drain contacts. Said source and drain contacts remain directly on said passivation layer. A method of the invention can thus further comprise, after the step of depositing said source and drain contacts directly on said passivation layer, and before the step of forming said gate contact, the step of etching, between said source and drain contacts, said passivation layer.

Preferably, in a method of the invention, said step of depositing said passivation layer is performed at a temperature comprised between (about) 700°C and (about) 1300°C.

Said passivation layer can comprise (or consist of) CN or GeN.

Preferably, said passivation layer is deposited to obtain a thickness comprised between (about) 1 nm and (about) 30 nm.

Preferably, in a method of the invention, said first active layer comprises (or consists of) a group III nitride semiconductor material, more particularly comprises (or consists of) GaN.

Preferably, in a method of the invention, said second active layer comprises (or consists of) a group III nitride semiconductor material, more particularly comprises (or consists of) AlGaN or AlGaInN.

A method of the invention can further comprise the step of depositing a spacer layer between said first active layer and said second active layer. Said spacer layer aims more particularly at increasing mobility in said two-dimensional electron gas layer. Preferably, said spacer layer comprises (or consists of) AlN.

A method of the invention can further comprise the step of depositing a third layer between said second active layer and said passivation layer. Said third layer can be used for doping purposes or for increasing the carrier density in the channel. Preferably, said third layer comprises (or consists of) a group III nitride semiconductor material, more particularly comprises (or consists of) GaN.

A method of the invention can further comprise the step of depositing a buffer layer between said substrate and said first active layer. Said buffer layer aims at providing an appropriate crystal structure transition between said substrate and the other layers. Preferably, said buffer layer comprises (or consists of) a group III nitride semiconductor material, and more particularly comprises (or consists of) AlN, GaN, AlGaN , InGaN and/or AlInGaN,

Preferably, in a method of the invention, said substrate comprises (or consists of) a material selected from the group consisting of silicon, sapphire, SiC, GaN and AIN.

A method according to the invention can be used for fabricating a group III-N field effect device, and more particularly for fabricating a HEMT, MOSHFET, MESFET, MISFET, or MISHFET device.

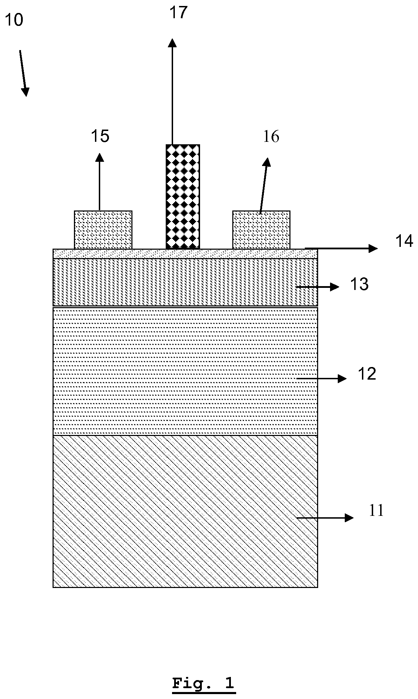

Figure 1 shows a HEMT device obtainable by a method in accordance with the present invention. The HEMT device (10) comprises:
- a substrate (11),
- a first active layer (12),
- a second active layer on said first active layer, said second active layer having a higher bandgap than said first active layer (13),
- a two-dimensional electron gas layer between said first active layer and said second active layer,
- a passivation layer on said second active layer (14),
- a source contact (15) and a drain contact (16), said source contact and said drain contacting said passivation layer.

The device can further comprise a gate (17) contact in electrical contact with the second active layer.

In the present invention, a passivation layer is deposited on the second active layer in-situ, at high temperature, in the MOCVD reactor chamber, prior to cooling down the structure and exposing the top surface to air contamination. The formation of the transistor, in particular the contact deposition, is then performed without any removal of the passivation layer prior to contact deposition, notably for the ohmic contact.

The MOVPE growth of such heterostructures, followed by the preparation of high electron mobility transistors on top of those heterostructures, with the technique suggested, allows for better performance of the transistor: higher current density, higher power performance compared to: (a) transistors prepared without any passivation, (b) transistors prepared with in-situ passivation or ex-situ between the drain and the source, (c) transistors prepared with in-situ passivation and removal of the passivation layer below the ohmic contacts. As an example, it allows for doubling of the current density, compared to a transistor prepared with ex-situ deposition of the passivation layer between the drain and source, which is actually the most widely used technique to develop group III-nitride devices nowadays.

In-situ passivation prevents any contamination of the surface prior to processing such that no oxidation of the surface of the second active layer occurs.

Secondly, as the passivation is deposited in-situ at high temperature, close to growth temperature, prior cooling down, it experiences the same cooling down step as the overall structure. The cooling down from growth temperature is thus different with and without the presence of the passivation layer. The presence of passivation layer allows increasing the Al content in the layer, without any cracking of the wafer. This allows for an increase of the 2DEG concentration.

The growth of those structures and the preparation of transistors with this technique such results in a device with the following characteristics:

First, improvement of the quality of ohmic contact formation of the device: lower contact resistance, very linear I-V characteristics, sheet resistances in agreement with material properties obtained by Hall measurement, showing that the total current capabilities which are present within the channel, can be extracted through the contacts. Deposition of the passivation layer allows for a better ohmic contact formation, with better control of uniformity over a wafer and reproducibility from one wafer to another, by passivating the surface and offering a better control of the surface states, as well a of the strain in the heterostructure, which is entirely controlled during MOVPE growth. In other words, improvement of ohmic contact uniformity and reproducibility

Secondly, better performance of the transistors such as a higher current density in DC mode because of passivation of the surface states.

Thirdly, reduction of the cracks appearance when cooling down the heterostructure from growth temperature to room temperature because the passivation layer is deposited at high temperatures on top of the second active layer. Therefore, it allows to increase the thickness of the second active layer. When the second active layer is AIGaN, increasing the thickness allows to increase the Al content in the top layer, and thus to increase the carrier density in the channel. Since the passivation layer is deposited at higher temperatures before cooling down, formation of cracks is reduced resulting in a higher Al content and thus a higher current density.

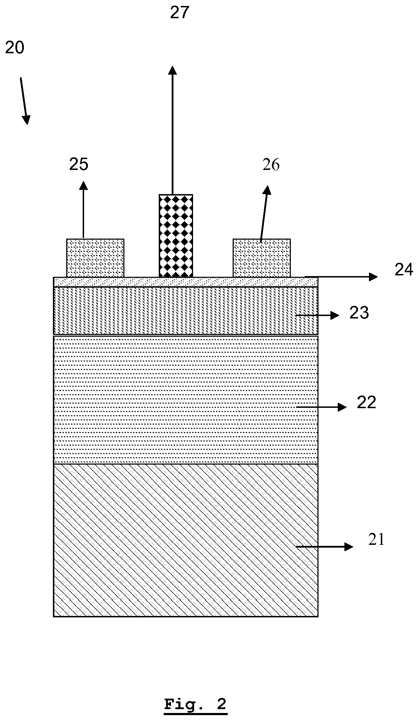

Figure 2 represents an AlGaN/GaN based HEMT (20) obtainable by a method in accordance with the present invention. The HEMT comprises a substrate (21). The substrate can be sapphire, SiC, Si or GaN.

The substrate can comprise a nucleation layer on the substrate to accommodate for the change in crystal parameters between substrate and layer.

A buffer layer can also be included on the substrate to provide for an appropriate crystal structure transition between the substrate and the remainder of the HEMT.

The HEMT (20) comprises a GaN (22) layer on the substrate and an AIGaN (23) layer on the GaN layer such that the GaN layer is sandwiched between the substrate and the AIGaN layer.

The GaN layer is typically between 1000 and 3000 nm thick, between 2000 and 3000 nm thick while the AlGaN layer is between 10 nm and 50 nm thick, or between 10 nm and 40 nm thick.

This top structure can be made of a single AlGaN layer, n-type doped or undoped, or a set of different layers doped or undoped layers, to increase confinement for the two-dimensional-electron gas.

The Al content can vary between 10% and 100%.

The GaN layer and the AlGaN layer are typically formed by MOCVD.

The HEMT (20) further comprises a passivation layer (24) on the AlGaN layer. The passivation layer covers the entire AIGaN layer or can partially cover the AIGaN layer. At least the regions where the source contact and the drain contact are formed should be covered by the passivation layer.

The passivation layer consists of an electron donating element and nitrogen, except SiN.

The AlGaN layer has a higher bandgap than the GaN layer.

Between the AlGaN layer and the GaN layer, surface charged layers could be created in the device. The surface charged layers are compensated by the formation of two-dimensional electron gas at the other side of the interface, resulting in high mobility values compared to the bulk material. This is beneficial for the creation of very high electron mobility channel in the device.

The HEMT further comprises a source contact (25) and a drain contact (26) on the passivation layer. The source contact and the drain contact are made of metals, preferably an alloy of different metals, which are deposited as layers and then annealed. The metals can be selected from the group consisting Ti, Al, Ni, Mo, Ta, Pt, Pd, V, Nb, Zr and/or Au.

The gate contact (27) is preferably formed of a material selected from the group consisting of Ti, Pt, Cr, Ni, Mo, Co, Au and Pd, combination thereof and alloys thereof.

During operation of the HEMT, the drain contact is biased at a predetermined potential while the source contact is grounded. Consequently, current will flow from the source to the drain in the channel and the 2DEG. The current flow is controlled by the bias and the potential applied to the gate electrode.

The presence of the passivation layer between AlGaN layer and the source contact and the drain contact respectively, results in an improved device performance.

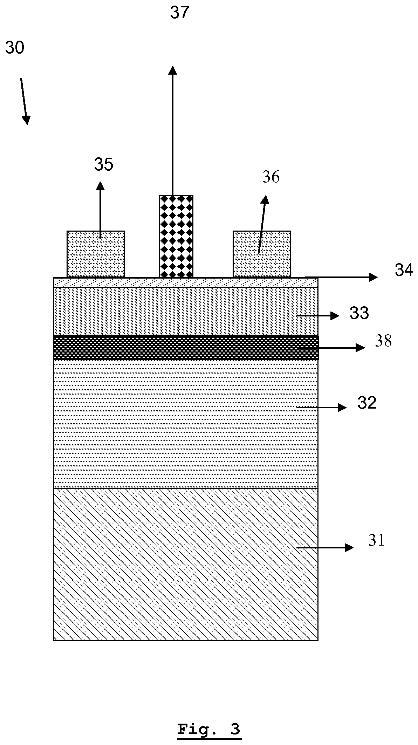

Figure 3 represents an AlGaN/AlN/GaN based HEMT (30) similar to the HEMT (20) in Figure 2.

The HEMT has similar layers comprising a substrate (31), a GaN layer (32), a AlGaN layer (33) and a passivation layer (34).

Further, the HEMT comprises a source electrode (35), a drain electrode (36) and a gate electrode (37).

The HEMT (30) further comprises an AlN layer (38) disposed on the GaN layer (32) between the GaN layer (32) and the AlGaN layer (33). The AlN layer allows to obtain a higher bandgap, thus a more narrow 2DEG channel en less penetration of the wavelfunction in the AlGaN layer, resulting in reduced scattering (reducing effect of interface roughness) thus increasing the mobility.

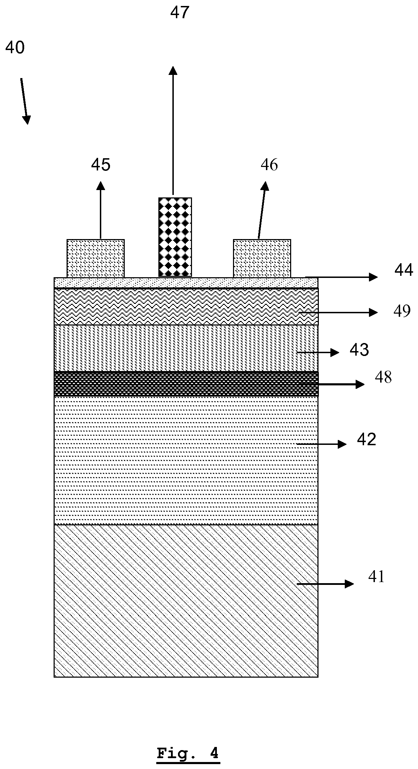

Figure 4 represents a GaN/AlGaN/AlN/GaN based HEMT (40) similar to the HEMT (20) in Figure 2.

The HEMT has similar layers comprising substrate (41), an GaN layer (42), a AlGaN layer (43) and a passivation layer (44).

The HEMT (40) further comprises an AlN layer (48) disposed on the GaN layer (42) between the GaN layer (42) and the AlGaN layer (43).

The HEMT (40) further comprises a GaN layer (49) on top op the AlGaN layer (43).

The passivation layer is deposited on top of the GaN layer (49). The GaN layer (49) can prevent oxidation of the AlGaN layer.

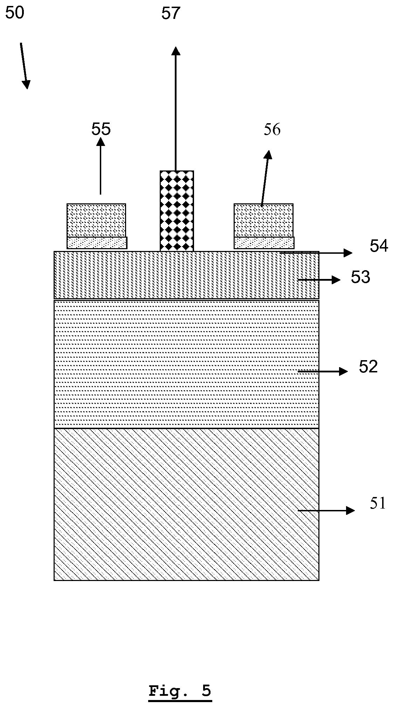

Figure 5 represents a AlGaN/GaN based HEMT (50) similar to the HEMT in Figure 2.

The HEMT has similar layers comprising a substrate (51), an AlGaN layer (52) and a GaN layer (53).

Further, the HEMT comprises a source electrode (55), a drain electrode (56) and a gate electrode (57).

The gate contact is in direct contact with the AlGaN layer, meaning that no passivation layer (54) is present between the gate contact and the Al GaN layer.

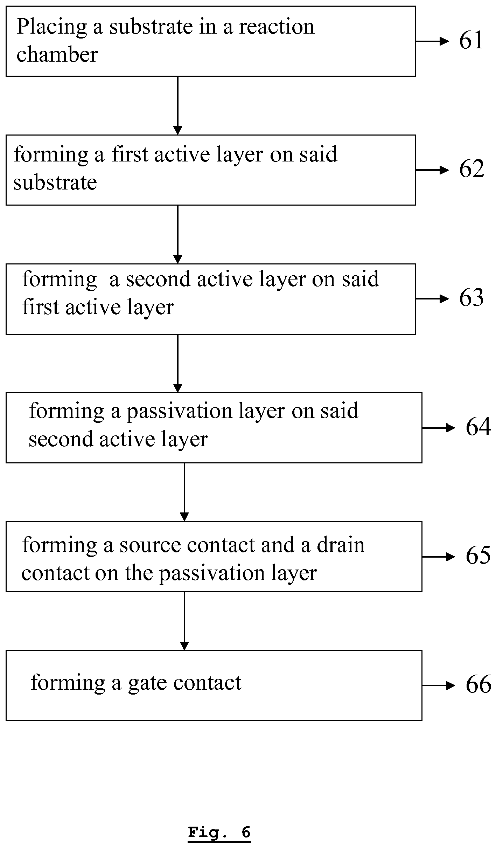

Figure 6 shows a method for forming a HEMT device, the method comprising the steps of :
- placing a substrate in a reaction chamber (61)
- forming a first active layer on said substrate (62)
- forming a second active layer on said first active layer, said second active layer having a higher bandgap than said first active layer, thereby forming a two-dimensional electron gas layer between said first active layer and said second active layer, (63)
- forming a passivation layer on said second active layer, (64)
- forming a source contact and a drain contact, said source contact and said drain contact contacting said passivation layer, with part of said passivation layer being uncovered by the source contact and the drain contact (65).

The method can further comprise the step of forming a gate contact in electrical contact with said second active layer (66). The gate contact is formed on the uncovered part of the passivation layer. This step is optional.

The steps of forming a first active layer, forming a second active layer and forming a passivation layer are performed in a MOCVD reactor chamber in a continuous process, meaning without subjecting the device to the air (for the purpose of this invention also called "in situ" formation). The formation of an oxide on the second active layer is substantially avoided. Moreover, the step of removing the oxide layer from the top surface of the second active layer is avoided. This results in an improved ohmic contact formation. The prior art shows that the oxide which spontaneously forms over the top surface of the second active layer is very stable, and thus requires high power and/or high duration of plasma etching prior effectively eliminating the oxide layer.

The processing of transistors on such structures consist of:
a. device isolation by plasma etching or by implantation,
b. deposition of the ohmic contact on the passivation layer (no etching). The metal layers are made of combination of different metal layers selected from the group consisting of Ti, Al, Ni, Mo, Ta, Pt, Pd, V, Nb, Zr and Au and alloys thereof,
c. annealing of the ohmic contact , deposition of a gate contact (e-beam or optical gates). The gate is preferably made of a material selected from the group consisting of Ti, Pt, Cr, Ni, Mo, Co, Au and Pd, combination thereof and alloys thereof,
d. optionally, deposition of a second passivation step between drain and source (which can be PECVD SiN , or SiO₂.)
e. any other lithography and metallization step for alignment purposes or thickening of the metal layers, which can take place before or after any of the preceding step.

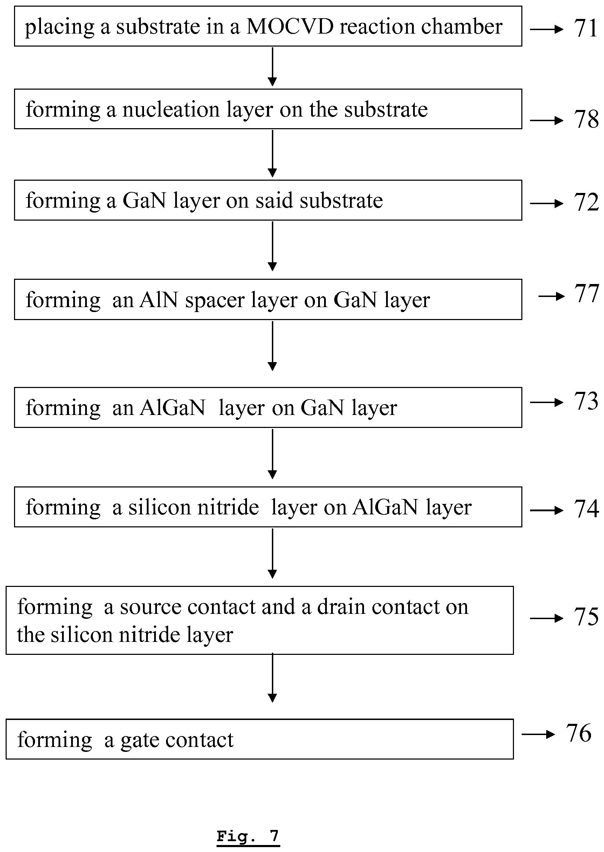

Figure 7 represents a method for forming an AlGaN/ GaN HEMT device that is not fully in accordance with the present invention, as it describes a passivation layer formed of SiN.

The AlGaN/GaN structures were grown by Metal-Organic Vapour Phase Epitaxy (MOVPE) on [0001] sapphire substrates. Starting compounds are trimethylgallium (TMGa), trimethylaluminium (TMAI), ammonia (NH₃) and silane (SiH₄, 200 ppm in hydrogen). The silane introduction line is modified in such a way that the amount of silane introduced in the reactor can be regulated from about 5 nmol/min up to about 1 µmol/min.

As first step (71) in the growth process, the substrates are annealed in H₂ at 1050° C at 53,33 mbar (40 torr). Then, nitridation of the surface is carried out at 800°C by introducing NH₃ into the reactor. After that, the substrates are cooled down to 525°C and a thin nucleation layer is grown (78) at 533,3 mbar (400 torr) by introducing TMGa into the reactor during 120 seconds. Subsequently, the temperature is ramped to 1020°C and at a pressure of 133,3 mbar (100 torr) GaN is grown to a thickness of 2.6 microns (72). Then, the growth is interrupted during 30 seconds while the reactor pressure is decreased to 53,33 mbar (40 torr). During 7-10 seconds, an AlN spacer layer (77) is grown followed by an AlₓGa₁₋ₓN layer (73) of thickness 20 to 22 nm.

After the last group III-N layer is grown at low pressure (below 266,6 mbar (200 torr)) and at high temperatures (typically between 950°C and 1200°C), the group III compound source is stopped, while keeping the NH₃ flow to the reactor and opening the SiH₄ line, allowing for growth of SiN at high temperature (74) After growth of a thin SiN layer (between 1 nm and 30 nm), the SiH₄ flow is stopped and the structure is cooled down to room temperature while keeping the NH₃ flow, to avoid desorption from the top layer. After cooling down the structure, the wafers are unloaded out of the reactor. The surface is very well protected by the SiN passivation layer.

The processing of transistors (steps 75 and 76) on such structures is similar to the process described above.

### EXAMPLES (not fully according to the invention, as the passivation layer is formed of SiN)

### Example 1.

AlGaN/GaN HEMT structures are grown at low pressure (133,3 mbar (100 Torr)) using Metal Organic Vapour Phase Epitaxy (MOVPE). As starting compounds, trimethyl gallium (TMGa), trimethyl alminium (TMAI) and ammonia (NH₃) are used.

The metal-organic precursors are transported with hydrogen as carrier gas; the amounts are regulated by means of mass flow controllers and the temperature of the thermostat baths in which the metal organic bubblers are mounted.

The flow of ammonia is also regulated by means of a mass flow controller and traces of water and oxygen are removed by an in-line filter.

Additionally, n-type doping of the GaN and (Al,Ga)N layers can be achieved by adding silane (SiH₄) during growth.

All gasses are introduced into the reactor via the so-called close-coupled showerhead.

After degassing the substrate at high temperatures (1100°C), a thin GaN buffer layer is deposited at lower temperature using NH₃ and TMGa.

The substrate temperature is then set to 1020C and a 2 micrometer thick semi-insulating GaN layer is grown.

After 2 micrometer, the pressure is lowered to 53,33 mbar (40 T), the temperature is raised to 1050°C and Al flow is sent to the reactor for deposition of AlₓGa-₁₋ₓN, with x included (comprised) between 20% and 40%. Typical thickness of AlGaN is 25 nm. The sources for III-type elements are then sent to the vent and SiH₄ is introduced in the reactor, simultaneously with NH₃, at the same pressure and temperature conditions as for AIGaN growth. SiN grows from NH₃ and SiH₄ at a growth rate of around 6nm/h. The SiN layer can also be grown at a growth rate of 0.3µ/h.

Transistors have then been prepared on these structures using standard processing, without any etching of the top SiN layer. Transfer Length method show a reduction of the ohmic contact resistance but also a large improvement of the I-V characteristic uniformity, giving sheet resistivity values in fair agreement with Hall measurements. Spectacular improvement of the dc characteristics is observed: drain-source current measurements for a positively biased gate (2V) show an increase of more than a factor two in current density from 0.5 A/mm in the reference sample to 1.2 A/mm with in-situ passivation, for a device width of 100 µm and a gate length of 0.2 µm. RF measurements show a ft of 40 GHZ and fₘₐₓ of 80 GHz, for the same device geometry. This is an increase in current density compared to results obtained with ex-situ SiN passivation. Further an improvement of DC and RF properties is observed.

### Example 2

The AlGaN/GaN HEMT structures were grown by MOVPE on [0001] sapphire substrates. A Thomas Swan close-coupled showerhead reactor was used with starting compounds trimethylgallium (TMGa), trimethylaluminium (TMAI), ammonia (NH₃) and diluted silane (SiH₄, 200 ppm in hydrogen). The silane introduction line is modified in such a way that the amount of silane introduced in the reactor can be regulated from the required amount for n-type doping of GaN (a few nmol/min up) to about 1 µmol/min.

After deposition of a thin GaN nucleation layer at low temperature, a 2.6 µm thick GaN layer is grown at 1020°C with a reactor pressure 133,3 mbar (100 Torr). Prior the AlGaN, a thin AlN spacer layer is grown at 53,33 mbar (40 Torr) to improve mobility in the 2DEG. Depending on samples, the top AlGaN layer is 22 to 24 nm thick and the Al content is 30 % as determined by High-Resolution X-Ray Diffraction measurements. After growth of the AlGaN layer, the reactor was purged during 10 seconds while maintaining the NH₃ flow. Then silane was introduced. Results on SiN thickness ranging from 3.5 to 15 nm are presented.

Transistors have been processed on these heterostructures. For the sake of comparison, similar structures without the in-situ grown SiN protecting layer have also been processed using the same technology, simultaneously. After mesa isolation by Cl₂-based plasma etching, Ti/Al/Pt/Au contacts were deposited on the SiN top layer, without any etching of the passivating layer and followed by rapid thermal annealing. Electron-beam lithography is used to pattern the gate Ni/Au Schottky contacts, to a dimension of 0.2 µm. A second Si₃N₄ passivating layer, now deposited by PECVD, protects the transistor.

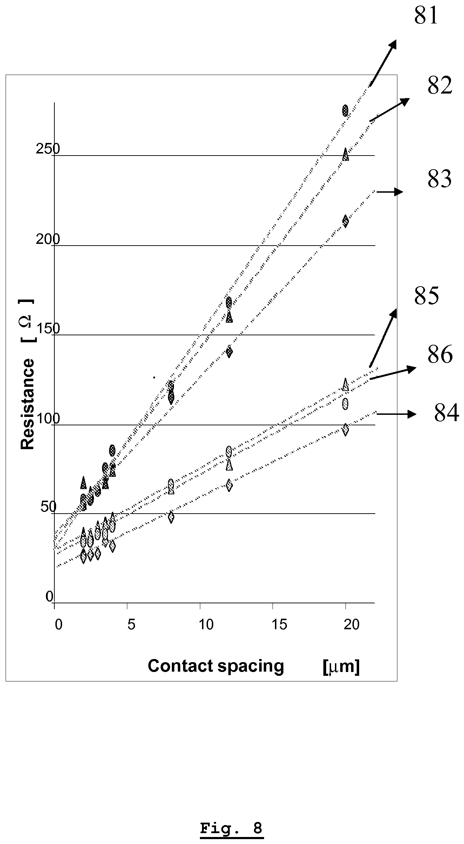

To assess the ohmic contact quality on the SiN capped heterostructures, Transfer Length Method (TLM) have been performed and are shown in Figure 8, for three different annealing temperatures.

The TLM measurements performed on uncapped HEMT structure (without SiN passivation layer) (81 at 820°C , 82 at 860°C , 83 at 900°C) give a best ohmic contact resistance of 1.49 Ωmm. However, for the three different annealing temperatures, the slope of the TLM line, which gives the sheet resistance, is different and varies between 395 and 528 Ω/sq.. These values are moreover higher than the sheet resistance value determined by Hall or by contact-less sheet resistivity measurements (Ω/sq.). In contrast, TLM measurements performed on the capped SiN epiwafers (with SiN passivation layers) (84 at 820°C , 85 at 860°C , 86 at 900°C) display a single sheet resistance value, in fair agreement with the other determinations of the sheet resistance values. Moreover, the ohmic contact resistance reduces to a value of 0.88 Ωmm, for a similar ohmic contact deposition scheme.

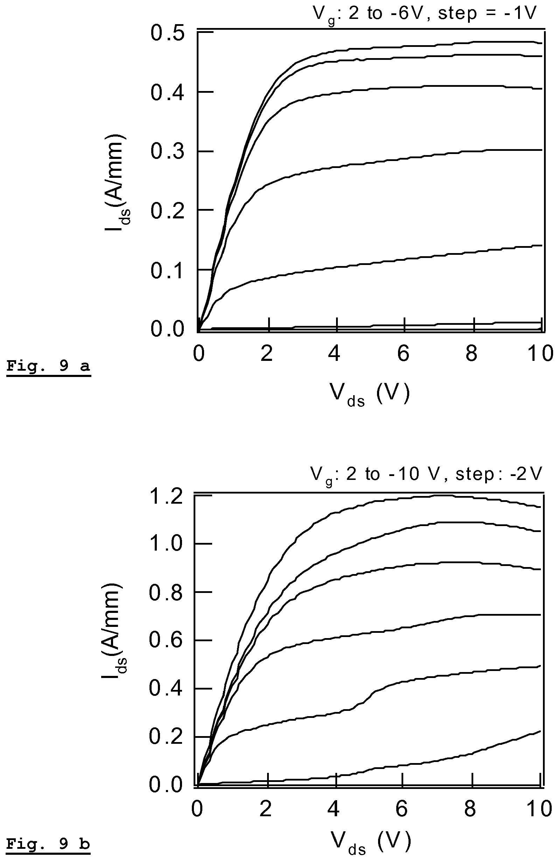

The DC drain source current-voltage characteristics for different gate bias voltages are given in Figure 9, for a device width of 100 µm and gate length of 0.2 µm; similar HEMT structure have been processed, one having no SiN passivation layer (also called uncapped) (a) and the other HEMT having a SiN passivation layer between the ohmic contacts and the AIGaN layer (also called capped in-situ), the passivation layer being a 7 nm thick SiN layer) (b). For a gate bias voltage of 2 V, the measurements show an improvement of more than a factor two in current density from 0.5 A/mm to 1.2 A/mm.

Small-signal RF measurements have been also performed on the transistors. Without in-situ SiN layer, ft and fₘₐₓ are respectively 24 GHz and 68 GHz, whereas for the in-situ passivated one, they give a ft of 40 GHz and fₘₐₓ of 80 GHz.

## Claims

1. A method for fabricating a semiconductor device (10,20,30,40,50) comprising the steps of:
- placing a substrate (11,21,31,41,51) in a reaction chamber,
- depositing a first active layer (12,22,32,42,52), said first active layer comprising a group III nitride semiconductor material,
- depositing on said first active layer a second active layer (13,23,33,43,53) having a higher bandgap than said first active layer, thereby forming a two-dimensional electron gas layer between said first active layer and said second active layer,
- depositing on said second active layer a passivation layer (14,24,34,44,54),
- depositing directly on said passivation layer a source contact (15,25,35,45,55) and a drain contact (16,26,36,46,56),
wherein :
• said steps of depositing said first, second active layers and said passivation layer are performed in said reaction chamber without subjecting the layers to air or environment,
the method being **characterized in that**:
• said passivation layer consists of an electron donating element and nitrogen, except SiN,
• said source and drain contacts are deposited entirely on said passivation layer.

2. A method for fabricating a semiconductor device according to claim 1 further comprising, before the step of depositing the source and drain contacts, the steps of:
- cooling said reaction chamber, and
- removing said device with its deposited layers from said reaction chamber.

3. A method for fabricating a semiconductor device according to claim 1 or 2, wherein said reaction chamber is a MOVPE or a MBE reaction chamber.

4. A method for fabricating a semiconductor device according to any of claims 1 to 3, further comprising the step of forming a gate contact (17,27,37,47,57) in electrical contact with said second active layer.

5. A method for fabricating a semiconductor device according to claim 4, wherein said gate contact is deposited directly on said passivation layer.

6. A method for fabricating a semiconductor device according to claim 4, further comprising after the step of depositing said source and drain contacts and before the step of forming said gate contact, the step of etching said passivation layer between said source and drain contacts.

7. A method for fabricating a semiconductor device according to any of claims 1 to 6, wherein said step of depositing said passivation layer is performed at a temperature comprised between 700°C and 1300°C.

8. A method for fabricating a semiconductor device according to any of claims 1 to 7, wherein said passivation layer consists of GeN or CN.

9. A method for fabricating a semiconductor device according to claim 1, wherein said first active layer comprises GaN.

10. A method for fabricating a semiconductor device according to any of claims 1 to 9, wherein said second active layer comprises a group III nitride semiconductor material.

11. A method for fabricating a semiconductor device according to claim 10, wherein said second active layer comprises AlGaN or AlGalnN.

12. A method for fabricating a semiconductor device according to any of claims 1 to 11, wherein said passivation layer is deposited to reach a thickness comprised between 1 nm and 30 nm.

13. A method for fabricating a semiconductor device according to any of claims 1 to 12 further comprising the step of depositing a spacer layer (38,48) between said first active layer and said second active layer, for increasing mobility in said two-dimensional electron gas layer.

14. A method for fabricating a semiconductor device according to claim 13, wherein said spacer layer comprises AlN.

15. A method for fabricating a semiconductor device according to any of claims 1 to 14 further comprising the step of depositing a third layer between said second active layer and said passivation layer for doping purposes or for increasing the carrier density in the channel.

16. A method for fabricating a semiconductor device according to claim 15, wherein said third layer comprises a group III nitride semiconductor material.

17. A method for fabricating a semiconductor device according to claim 16, wherein said third layer comprises GaN.

18. A method for fabricating a semiconductor device according to any of claims 1 to 17 further comprising the step of depositing a buffer layer between said substrate and said first active layer for providing an appropriate crystal structure transition between said substrate and the other layers.

19. A method for fabricating a semiconductor device according to claim 18, wherein said buffer layer comprises a group III nitride semiconductor material.

20. A method for fabricating a semiconductor device according to claim 19, wherein said buffer layer comprises AlN, GaN, AlGaN and/or AlInGaN

21. A method for fabricating a semiconductor device according to any of claims 1 to 20, wherein said substrate comprises a material selected from the group consisting of silicon, sapphire, SiC, GaN and AlN.

22. A method for fabricating a HEMT, MOSHFET, MESFET, MISFET, or MISHFET device comprising a method according to any of claims 1 to 21.

## Patentansprüche

1. Verfahren zur Herstellung einer Halbleitervorrichtung (10, 20, 30, 40, 50), wobei das Verfahren die Schritte umfasst:
- Platzieren eines Substrats (11, 21, 31, 41, 51) in einer Reaktionskammer,
- Abscheiden einer ersten aktiven Schicht (12, 22, 32, 42, 52), wobei die besagte erste aktive Schicht ein Gruppe-III-Nitridhalbleitermaterial umfasst,
- Abscheiden einer zweiten aktiven Schicht (13, 23, 33, 43, 53) mit einer höheren Bandlücke als die besagte erste aktive Schicht auf der besagten ersten aktiven Schicht, wodurch zwischen der besagten ersten aktiven Schicht und der besagten zweiten aktiven Schicht eine zweidimensionale Elektronengasschicht gebildet wird,
- Abscheiden einer Passivierungsschicht (14, 24, 34, 44, 54) auf der besagten zweiten aktiven Schicht,
- Direktes Abscheiden eines Source-Kontakts (15, 25, 35, 45, 55) und eines Drain-Kontakts (16, 26, 36, 46, 56) auf der besagten Passivierungsschicht,
wobei:
• die besagten Schritte des Abscheidens der besagten ersten und der besagten zweiten aktiven Schicht sowie der besagten Passivierungsschicht in der Reaktionskammer ausgeführt werden, ohne die Schichten Luft oder der Umgebung auszusetzen,
wobei das Verfahren **dadurch gekennzeichnet ist, dass**:
• die besagte Passivierungsschicht aus einem Elektronenspenderelement und Stickstoff, ausgenommen SiN, besteht,
• der Source- und der Drain-Kontakts gänzlich auf die besagten Passivierungsschicht abgeschieden werden.

2. Verfahren zur Herstellung einer Halbleitervorrichtung nach Anspruch 1, vor dem Schritt des Abscheidens des Source- und des Drain-Kontakts ferner folgende Schritte umfassend:
- Kühlen der besagten Reaktionskammer, und
- Entnehmen der Vorrichtung mit ihren abgeschiedenen Schichten aus der Reaktionskammer.

3. Verfahren zur Herstellung einer Halbleitervorrichtung nach Anspruch 1 oder 2, wobei die Reaktionskammer eine MOVPE(metallorganische Gasphasenepitaxie)- oder eine MBE(Molekularstrahlepitaxie)-Reaktionskammer ist.

4. Verfahren zur Herstellung einer Halbleitervorrichtung nach einem der Ansprüche 1 bis 3, ferner den Schritt des Bildens eines Gate-Kontakts (17, 27, 37, 47, 57) in elektrischem Kontakt mit der besagten zweiten aktiven Schicht umfassend.

5. Verfahren zur Herstellung einer Halbleitervorrichtung nach Anspruch 4, wobei der besagte Gate-Kontakt direkt auf die besagten Passivierungsschicht abgeschieden wird.

6. Verfahren zur Herstellung einer Halbleitervorrichtung nach Anspruch 4, ferner nach dem Schritt des Abscheidens des besagten Source- und des Drain-Kontakts und vor dem Schritt des Bildens des besagten Gate-Kontakts, den Schritt des Ätzens der besagten Passivierungsschicht zwischen den besagten Source- und dem Drain-Kontakts umfassend.

7. Verfahren zur Herstellung einer Halbleitervorrichtung nach einem der Ansprüche 1 bis 6, wobei der besagte Schritt des Abscheidens der besagten Passivierungsschicht bei einer Temperatur zwischen 700 °C und 1300 °C ausgeführt wird.

8. Verfahren zur Herstellung einer Halbleitervorrichtung nach einem der Ansprüche 1 bis 7, wobei die besagte Passivierungsschicht aus GeN oder CN besteht.

9. Verfahren zur Herstellung einer Halbleitervorrichtung nach Anspruch 1, wobei die besagte erste aktive Schicht GaN umfasst.

10. Verfahren zur Herstellung einer Halbleitervorrichtung nach einem der Ansprüche 1 bis 9, wobei die besagte zweite aktive Schicht ein Gruppe-III-Nitridhalbleitermaterial umfasst.

11. Verfahren zur Herstellung einer Halbleitervorrichtung nach Anspruch 10, wobei die besagte zweite aktive Schicht AlGaN oder AlGaInN umfasst.

12. Verfahren zur Herstellung einer Halbleitervorrichtung nach einem der Ansprüche 1 bis 11, wobei die besagte Passivierungsschicht abgeschieden wird, um eine Dicke zwischen 1 nm und 30 nm zu erreichen.

13. Verfahren zur Herstellung einer Halbleitervorrichtung nach einem der Ansprüche 1 bis 12, ferner den Schritt des Abscheidens einer Abstandshalterschicht (38, 48) zwischen der besagten ersten aktiven Schicht und der besagten zweiten aktiven Schicht umfassend, um die Mobilität in der besagten zweidimensionalen Elektronengasschicht zu erhöhen.

14. Verfahren zur Herstellung einer Halbleitervorrichtung nach Anspruch 13, wobei die besagte Abstandshalterschicht AlN umfasst.

15. Verfahren zur Herstellung einer Halbleitervorrichtung nach einem der Ansprüche 1 bis 14, ferner den Schritt des Abscheidens einer dritten Schicht zwischen der besagten zweiten aktiven Schicht und derbesagten Passivierungsschicht zu Dotierungszwecken umfassend, und um die Trägerdichte in dem Kanal zu erhöhen.

16. Verfahren zur Herstellung einer Halbleitervorrichtung nach Anspruch 15, wobei die besagte dritte Schicht ein Gruppe-III-Nitridhalbleitermaterial umfasst.

17. Verfahren zur Herstellung einer Halbleitervorrichtung nach Anspruch 16, wobei die besagte dritte Schicht GaN umfasst.

18. Verfahren zur Herstellung einer Halbleitervorrichtung nach einem der Ansprüche 1 bis 17, ferner den Schritt des Abscheidens einer Pufferschicht zwischen dem besagten Substrat und der besagten ersten aktiven Schicht umfassend, um einen geeigneten Kristallstrukturübergang zwischen dem Substrat und den anderen Schichten bereitzustellen.

19. Verfahren zur Herstellung einer Halbleitervorrichtung nach Anspruch 18, wobei die besagte Pufferschicht ein Gruppe-III-Nitridhalbleitermaterial umfasst.

20. Verfahren zur Herstellung einer Halbleitervorrichtung nach Anspruch 19, wobei die besagte Pufferschicht AlN, GaN, AlGaN, und/oder AlInGaN umfasst.

21. Verfahren zur Herstellung einer Halbleitervorrichtung nach einem der Ansprüche 1 bis 20, wobei das besagte Substrat ein Material umfasst, das aus der Gruppe ausgewählt wird, die aus Silikon, Saphir, SiC, GaN und AlN besteht.

22. Verfahren zur Herstellung einer HEMT-, MOSHFET-, MESFET, MISFET- oder MISHFET-Vorrichtung, ein Verfahren nach einem der Ansprüche 1 bis 21 umfassend.

## Revendications

1. Procédé de fabrication d'un dispositif semi-conducteur (10, 20, 30, 40, 50) comprenant les étapes de :
- mise en place d'un substrat (11, 21, 31, 41, 51) dans une chambre de réaction,
- dépôt d'une première couche active (12, 22, 32, 42, 52), ladite première couche active comprenant un matériau semi-conducteur au nitrure de groupe III,
- dépôt sur ladite première couche active d'une deuxième couche active (13, 23, 33, 43, 53) ayant une bande interdite plus élevée que ladite première couche active, formant ainsi une couche de gaz électronique bidimensionnelle entre ladite première couche active et ladite deuxième couche active,
- dépôt sur ladite deuxième couche active d'une couche de passivation (14, 24, 34, 44, 54),
- dépôt directement sur ladite couche de passivation d'un contact de source (15, 25, 35, 45, 55) et d'un contact de drain (16, 26, 36, 46, 56),
dans lequel :
• lesdites étapes de dépôt desdites première, deuxième couche actives et de ladite couche de passivation sont effectuées dans ladite chambre de réaction sans soumettre les couches à l'air ou à l'ambiance, le procédé étant **caractérisé en ce que** :
• ladite couche de passivation est constituée d'un élément donateur d'électrons et d'azote, à l'exception du SiN,
• lesdits contacts de source et de drain sont déposés entièrement sur ladite couche de passivation.

2. Procédé de fabrication d'un dispositif semi-conducteur selon la revendication 1, comprenant en outre, avant l'étape de dépôt des contacts de source et de drain, les étapes de :
- refroidissement de ladite chambre de réaction, et
- retrait dudit dispositif avec ses couches déposées de ladite chambre de réaction.

3. Procédé de fabrication d'un dispositif semi-conducteur selon la revendication 1 ou 2, dans lequel ladite chambre de réaction est une chambre de réaction MOVPE ou MBE.

4. Procédé de fabrication d'un dispositif semi-conducteur selon l'une quelconque des revendications 1 à 3, comprenant en outre l'étape de formation d'un contact de grille (17, 27, 37, 47, 57) en contact électrique avec ladite deuxième couche active.

5. Procédé de fabrication d'un dispositif semi-conducteur selon la revendication 4, dans lequel ledit contact de grille est déposé directement sur ladite couche de passivation.

6. Procédé de fabrication d'un dispositif semi-conducteur selon la revendication 4, comprenant en outre, après l'étape de dépôt desdits contacts de source et de drain et avant l'étape de formation dudit contact de grille, l'étape de gravure de ladite couche de passivation entre lesdits contacts de source et de drain.

7. Procédé de fabrication d'un dispositif semi-conducteur selon l'une quelconque des revendications 1 à 6, dans lequel ladite étape de dépôt de ladite couche de passivation est effectuée à une température comprise entre 700 °C et 1300 °C.

8. Procédé de fabrication d'un dispositif semi-conducteur selon l'une quelconque des revendications 1 à 7, dans lequel ladite couche de passivation est constituée de GeN ou de CN.

9. Procédé de fabrication d'un dispositif semi-conducteur selon la revendication 1, dans lequel ladite première couche active comprend du GaN.

10. Procédé de fabrication d'un dispositif semi-conducteur selon l'une quelconque des revendications 1 à 9, dans lequel ladite deuxième couche active comprend un matériau semi-conducteur au nitrure de groupe III.

11. Procédé de fabrication d'un dispositif semi-conducteur selon la revendication 10, dans lequel ladite deuxième couche active comprend de l'AlGaN ou de l'AlGaInN.

12. Procédé de fabrication d'un dispositif semi-conducteur selon l'une quelconque des revendications 1 à 11, dans lequel ladite couche de passivation est déposée pour atteindre une épaisseur comprise entre 1 nm et 30 nm.

13. Procédé de fabrication d'un dispositif semi-conducteur selon l'une quelconque des revendications 1 à 12, comprenant en outre l'étape de dépôt d'une couche d'espacement (38, 48) entre ladite première couche active et ladite deuxième couche active, pour augmenter la mobilité dans ladite couche de gaz électronique bidimensionnelle.

14. Procédé de fabrication d'un dispositif semi-conducteur selon la revendication 13, dans lequel ladite couche d'espacement comprend de l'AlN.

15. Procédé de fabrication d'un dispositif semi-conducteur selon l'une quelconque des revendications 1 à 14, comprenant en outre l'étape de dépôt d'une troisième couche entre ladite deuxième couche active et ladite couche de passivation à des fins de dopage ou pour augmenter la densité de porteurs dans le canal.

16. Procédé de fabrication d'un dispositif semi-conducteur selon la revendication 15, dans lequel ladite troisième couche comprend un matériau semi-conducteur au nitrure de groupe III.

17. Procédé de fabrication d'un dispositif semi-conducteur selon la revendication 16, dans lequel ladite troisième couche comprend du GaN.

18. Procédé de fabrication d'un dispositif semi-conducteur selon l'une quelconque des revendications 1 à 17, comprenant en outre l'étape de dépôt d'une couche tampon entre ledit substrat et ladite première couche active pour fournir une transition de structure cristalline appropriée entre ledit substrat et les autres couches.

19. Procédé de fabrication d'un dispositif semi-conducteur selon la revendication 18, dans lequel ladite couche tampon comprend un matériau semi-conducteur au nitrure de groupe III.

20. Procédé de fabrication d'un dispositif semi-conducteur selon la revendication 19, dans lequel ladite couche tampon comprend de l'AlN, du GaN, de l'AlGaN et/ou de l'AlInGaN.

21. Procédé de fabrication d'un dispositif semi-conducteur selon l'une quelconque des revendications 1 à 20, dans lequel ledit substrat comprend un matériau choisi dans le groupe constitué de silicium, saphir, SiC, GaN et AlN.

22. Procédé de fabrication d'un dispositif HEMT, MOSHFET, MESFET, MISFET ou MISHFET comprenant le procédé selon l'une quelconque des revendications 1 à 21.
